# DEMANDE DE BREVET EUROPEEN

(11) **EP 1 280 394 A1**
(43) Date de publication de la demande: **29.01.2003**
(21) Numéro de dépôt: 02077900.5
(22) Date de dépôt: 17.07.2002
(51) Int. Cl.: H05K 3/46, H01H 1/40

(54) **Appareil comportant des contacts faits de pistes de carbone et procédé pour les réaliser**

(30) Priorité: 26.07.2001 FR 0110010
(71) Demandeur: Koninklijke Philips Electronics N.V., 5621 BA Eindhoven (NL)
(72) Inventeur: Farizon, Hubert, 75008 Paris (FR); Grigne, Jean-Michel, 75008 Paris (FR)
(74) Mandataire: Chaffraix, Jean

(57) **Abrégé**

Cet appareil comporte une plaque de circuit imprimé 10 et des contacts faits de pistes de carbone. Ces pistes de carbone ( 52, 44) sont disposées sur la plaque de circuit imprimé (10) par l'intermédiaire d'une couche isolante (54 42) plaquée sur la plaque de circuit imprimé.

Application : Réalisation de clavier pour téléphone mobile.

## Description

L'invention concerne un appareil comportant une plaque de circuit imprimé et des contacts faits de pistes de carbone.

L'invention concerne aussi un procédé pour fabriquer de tels contacts.

L'invention trouve d'importantes applications notamment en ce qui concerne la réalisation de claviers sur des appareils de petite taille.

Ainsi, par exemple, pour limiter l'encombrement des appareils de radiotéléphonie mobile, les contacts des boutons du clavier sont disposés à même sur la plaque de circuit imprimé qui contient pratiquement tous les composants de l'appareil. Ces plaques de circuit imprimé se composent d'une pluralité de couches, typiquement 2 à 4 couches. Ces couches sont traversées de part en part par de nombreux trous placés très près l'un de l'autre.

Le problème qui se pose, alors, est dû aux contacts du clavier se présentant sous forme de pistes en carbone. La présence des trous gêne le tracé des pistes, et le dépôt du carbone risque de s'infiltrer dans lesdits trous.

La présente invention propose un appareil du genre mentionné dans le préambule qui permet l'utilisation de pistes en carbone tout en gardant un prix de revient bas.

Pour cela, un tel appareil est remarquable en ce que les pistes de carbone sont disposées sur la plaque de circuit imprimé par l'intermédiaire d'une couche isolante plaquée sur la plaque de circuit imprimé.

Un procédé pour fabriquer un tel clavier comporte les étapes suivantes :
- bouchage, au moins partiellement, au moins desdits trous,
- dépôt d'une couche isolante à même ladite plaque de circuit imprimé,
- dépôt des pistes de carbone pour ledit clavier.

La description suivante, faite en regard des dessins ci-annexés, le tout donné à titre d'exemples non limitatifs fera bien comprendre comment l'invention peut être réalisée. Sur les dessins :
La figure 1 montre un appareil conforme à l'invention.
La figure 2 montre un premier mode de réalisation de l'invention.
La figure 3 montre un deuxième mode de réalisation de l'invention.

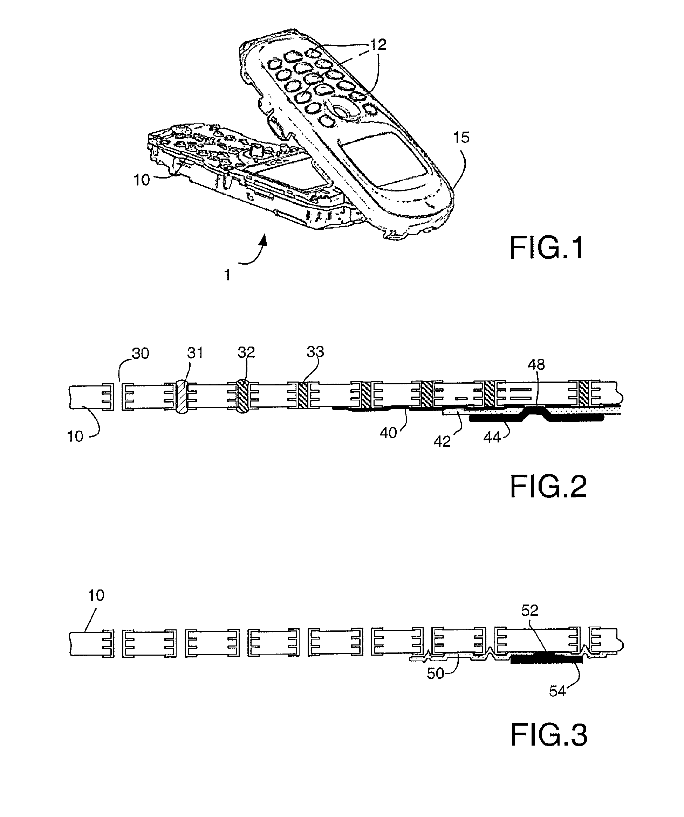

A la figure 1, l'appareil porte la référence 1. Cet appareil, dans le cadre de l'exemple décrit, est un radio téléphone mobile pour réseau cellulaire. Cet appareil est montré selon une vue éclatée qui laisse voir la plaque de circuit imprimé 10 qui contient à peu près tous les composants électroniques de cet appareil. Cet appareil comporte un clavier dont les touches 12 sont visibles sur la face avant 15 de l'appareil.

La plaque de circuit imprimé 10 comporte une multitude de trous ou de traversées (appelées via en littérature anglo-saxonne). La figure 2 montre comment ces trous sont traités pour la mise en application de l'invention. A la figure 2, la référence 30 montre un trou débouchant tel qu'il se présente à l'origine.

Selon l'invention, cette traversée est tout d'abord bouchée par un matériau de bouchage quelconque. Ceci est montré par la référence 31. Ce produit de bourrage est ensuite durci au four par exemple pour le rendre plus facile à usiner. Ceci est montré par la référence 32. Le bourrage est ensuite arasé, comme cela est montré par la référence 33. Sur les trous du côté du clavier on place une couche de résine 40 (resist) pour niveler la surface. Sur cette résine 40 on place une couche d'une matière isolante 42 sur laquelle la couche de carbone 44. destinée au clavier est enfin placée. Le contact entre cette piste en carbone est assuré par une zone dorée 48 du circuit imprimé.

Un autre mode de réalisation est montré à la figure 3. Selon ce mode, on utilise des feuilles photo sensibles 50 pour rendre plus plate la plaque de circuit imprimé 10. Cette feuille est une feuille VACREL fabriquée par Dupont. Ce produit se polymérise aux rayons ultra violets et durcit suffisamment pour la mise en oeuvre de l'invention. En outre, on a pu ainsi ménager la zone de contact 52 sur la plaque 10. Cette feuille permet l'accrochage des pistes de carbone 54 pour les touches 12 du clavier.

Bien que l'on ait décrit l'invention dans le cadre de clavier, il va de soi qu'elle couvre tous les cas où il est question de déposer une couche de carbone sur une plaque ayant des protubérances.

## Revendications

1. Appareil comportant une plaque de circuit imprimé et des contacts faits de pistes de carbone, **caractérisé en ce que** les pistes de carbone sont disposées sur la plaque de circuit imprimé par l'intermédiaire d'une couche isolante plaquée sur la plaque de circuit imprimé.

2. Appareil selon la revendication 1, **caractérisé en ce qu'**une couche intermédiaire de nivellement est plaquée entre la plaque de circuit imprimé et ladite couche isolante.

3. Appareil selon la revendication 1, **caractérisé en ce que** les couches isolantes et de nivellement sont réalisées par une couche isolante faite en un matériau du genre connu sous le nom de VACREL.

4. Procédé pour réaliser des contacts en pistes de carbone sur une plaque de circuit imprimé comportant une multitude de traversées, **caractérisé en ce qu'**il comporte les étapes suivantes :
- bouchage, au moins partiellement, au moins desdites traversées,
- dépôt d'une couche isolante à même ladite plaque de circuit imprimé,
- dépôt des pistes de carbone pour ledit clavier.

5. Procédé selon la revendication 4, **caractérisé en ce qu'**une étape supplémentaire est prévue pour insérer contre la plaque de circuit imprimé une couche intermédiaire de nivellement.

6. Procédé selon la revendication 4, **caractérisé en ce que** le dépôt de la couche isolante faite notamment en un matériau connu sous le nom de VACREL constitue aussi le dépôt de la couche de nivellement.

7. Appareil selon l'une des revendications 1 à 3, **caractérisé en ce qu'**il comporte un clavier dont les contacts sont réalisés par des pistes en carbone.
